# EUROPEAN PATENT SPECIFICATION

(11) **EP 1 793 424 B1**
(45) Date of publication and mention of the grant of the patent: **05.10.2011**
(21) Application number: 05765318.0
(22) Date of filing: 04.07.2005
(51) Int. Cl.: H01L 27/10, H01L 27/24, H01L 45/00

(54) **NONVOLATILE MEMORY**
NICHTFLÜCHTIGER SPEICHER
MÉMOIRE NON VOLATILE

(30) Priority: 08.09.2004 JP 2004260642
(43) Date of publication of application: 06.06.2007
(73) Proprietor: Renesas Electronics Corporation, Kanagawa 211-8668 (JP)
(72) Inventor: MATSUZAKI, Nozomu,, Kokubunji-shi, Tokyo 1858601 (JP); TERAO, Motoyasu,, Kokubunji-shi, Tokyo 1858601 (JP)
(74) Representative: Beetz & Partner
(86) International application number: PCT/JP2005/012324
(87) International publication number: WO 2006/027887

(56) References cited:
- JP-A- 4 045 584
- JP-A- 4 045 585
- JP-A- 2001 502 848
- JP-A- 2004 193 282
- US-A- 5 177 567
- US-A1- 2001 049 189
- US-A1- 2002 086 524

## Description

### Technical Field

The present invention relates to a non-volatile storage device that is formed on the same substrate as that of a semiconductor device and is used together with the semiconductor device, and the non-volatile storage device is formed of a metal compound. This technique is concerned with a semiconductor non-volatile storage device or a semiconductor arithmetic-logic device in which a non-volatile storage device is mounted.

### Background Art

It is known that there is a non-volatile storage device that uses a crystalline state and a noncrystalline state of a metal compound as storage information. The non-volatile storage device stores information by using a difference between a crystalline state and a noncrystalline state of a material. Generally, a tellurium compound is used as the material for the non-volatile storage device. The principles of storing information based on a difference in reflectivity between the noncrystalline state and the crystalline state of the material are widely used in an optical recording medium such as a DVD (Digital Versatile Disc).

In recent years, a method has been proposed for using the principles concerned in electrical information storage. Unlike the optical technique, the above method is to detect a difference in electrical resistance between a noncrystalline state and a crystalline state, that is, a high resistance of the noncrystalline state and a low resistance of the crystalline state, based on an amount of current or a change in voltage. Non-Patent Document 1 ("A Novel Cell Technology Using N-Doped GeSbTe Films for Phase Change RAM", Abstracts of IEEE, 2003 Symposium on VLSI Technology, pp. 177 to 178) and the like are given as a known technique which has been previously published. In addition, Patent Document 1 (Japanese Patent Laid-open No. 2003-100085) and the like are given as a known patent which has been previously published. The present invention relates to the latter, that is, the electrical information storage.

The feature of the principles of the above electrical information storage is that information can be rewritten with a much higher speed than a conventional semiconductor non-volatile storage device (a floating gate type storage device and a storage device in which electrons are captured in a nitrogen film). The use of the storage principles results in that it is possible to improve the delay accompanying the rewriting of information in the non-volatile storage device, and also it is possible to dramatically enhance the performance of the system using the non-volatile storage device. In order to attain these improvements, the device utilizing the storage principles described above needs to be incorporated in the form of non-volatile storage device on the semiconductor device similarly to the conventional systems. When the non-volatile storage device concerned is incorporated in the semiconductor device and the electrical information is rewritten to the non-volatile storage device concerned, the Joule heat is utilized which is generated when a current is caused to flow through the material which is used in the non-volatile storage device concerned or a heating element disposed in the vicinity of the material. When the material is intended to be changed from the crystalline state to the noncrystalline state, the heat is generated with a high voltage and a large current to heat the material to its melting point, and the material is then rapidly cooled. On the other hand, when the material is intended to be changed from the noncrystalline state to the crystalline state, an amount of heat generated is controlled, that is, the applied voltage and the supplied current are limited so that a temperature of the material reaches a crystallization temperature (generally lower than the melting point). In such an operation, it is important how high-speed rewriting is realized. However, any of known techniques does not disclose information about this technical point.

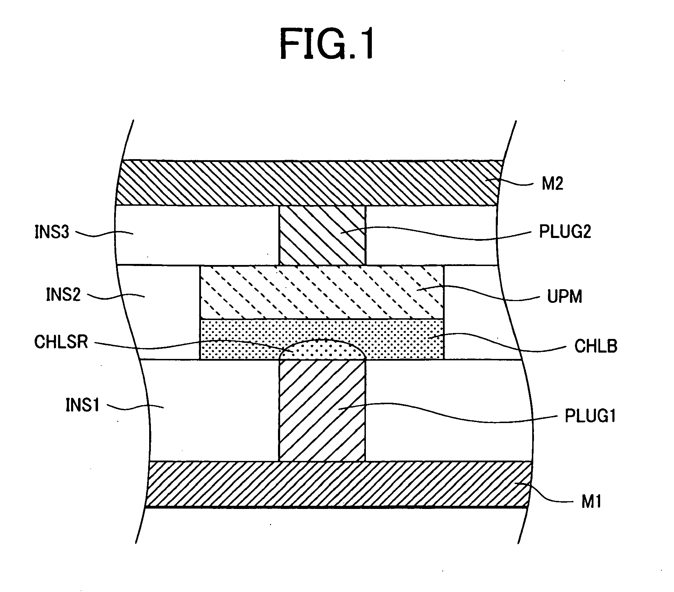

In addition, another problem of the storage principles is to increase the time to maintain information that has been stored. In the material concerned, the noncrystalline state is a metastable state. Thus, when a given time elapsed while the material in the noncrystalline state is left as it is, the material is changed from the noncrystalline state to the crystal state which is stable in terms of the energy. That is to say, the information which is stored in the noncrystalline state is erased due to the crystallization. In order to ensure the reliability, it is important to increase the time to change from the noncrystalline state to the crystalline state. However, since the crystal grows around a crystalline nucleus in terms of its properties, it is uneasy to prolong the time required for the crystallization. This problem will now be described by giving, as an example, the case where a structure as shown in FIG. 1 is adopted. Reference symbol M1 designates a lower wiring layer, reference symbol INS1 designates an insulating layer covering M1, and reference symbol PLUG1 designates a columnar wiring layer which extends upward from M1 so as to penetrate through INS1. Also, reference symbol CHL designates a variable resistance material, reference symbol UPM designates an upper electrode which is disposed so as to contact an upper portion of CHL, reference symbol INS2 designates an insulating layer, reference symbol INS3 designates an insulating layer covering UPM, reference symbol M2 designates an upper wiring layer, and reference symbol PLUG2 designates a columnar electrode through which UPM and M2 are connected to each other. To change the state to the noncrystalline state, a current is caused to flow across M1 and M2. However, this current is caused to flow from UPM into a layer CHLB to intensively flow to PLUG1 having a small diameter. For this reason, a portion on PLUG1 is mainly heated. Thus, a portion which is changed from the crystalline state to the noncrystalline state is limited to the extremely partial region (CHLSR), and no temperature sufficiently rises in a peripheral portion which is not included in the current path, so that the peripheral portion is left in the crystalline state (CHLB). With this structure, there is the possibility that since there is a surface at which a noncrystalline portion contacts a crystalline portion, the crystallization progresses from the surface, thereby to shorten the time to maintain information stored. A structure disclosed in the Non-Patent Document 1 ("A Novel Cell Technology Using N-Doped GeSbTe Films for Phase Change RAM" (IEEE, VLSI Technology Symposium 2003), 2003, pp. 177 to 178) corresponds to this structure. The Patent Document 1 adopts a structure in which all of an upper bottom portion and a lower bottom portion of a variable resistance material function as electrodes. Thus, in this structure, it is thought that the entire inside of the variable resistance material is heated. However, a silicon material exists right under a lower electrode. For this reason, the heat radiation on the lower electrode side becomes slightly poor, and thus even when the material is amorphized, the crystal is left on the lower electrode side. As a result, it is possible to shorten the time to maintain information that has been stored.

Patent Document 1: Japanese Patent Laid-open No. 2003-100085
Non-Patent Document 1: "A Novel Cell Technology Using N-Doped GeSbTe Films for Phase Change RAM", Abstracts of IEEE, VLSI Technology Symposium 2003, 2003, pp. 177 to 178

Document US 2002/0086524 A1 describes a memory device using phase change materials that can be electrically switched between a generally amorphous and a generally crystalline state. To achieve the current density of between 10⁵ and 10⁷ A/cm² required for a phase change, an "active region" is formed in the element by contacting the phase change material with an electrode having a smaller size than the material. Since the current spread is reduced by the size of the electrode, the active region, where the phase change takes place, is smaller than the size of the phase change material.

Patent application US 2001/0049189 A1 discloses a memory element based on a phase change material where the active region of the phase change material is limited by the size of one of the electrodes contacting it. For reducing the lateral dimension of the electrode below the photolithographic limit, a pore is etched in the substrate with its sidewalls then covered by a disposable space leaving an ultrasmall opening in the substrate, which is then filled with conductive material to form the small size electrode.

Patent specification US 5,177,567 describes a solid state memory and threshold switch device where a chalcogenide material is sandwiched between two electrodes. The size of the electrodes is smaller than that of the chalcogenide material. At the interfaces between the chalcogenide material and the electrodes a carbon layer is provided for reducing the contamination of the chalcogenide material by the electrode material.

For reducing the current value required to achieve the current density necessary for generating a phase change in a chalcogenide semiconductor material, Japanese patent applications JP 04045584 A and JP 04045585 A disclose the deposition of a chalcogenide semiconductor material within a small hole formed in an insulator material provided between an upper and a lower electrode of larger size than the hole.

### Disclosure of the Invention

### Problems to be Solved by the Invention

An object of the present invention is to provide a non-volatile storage device capable of storing information by switching between a crystalline state and a noncrystalline state with use of heat and electrically reading out the information, the non-volatile storage device having a structure in which thermal conductivity of a material that contacts a material having a variable resistance is higher than that of an insulating film that does not contact the material having a variable resistance, and which can realize the above object.

### Means for Solving the Problems

These problems are solved by the device defined by claim 1.

In order to realize high-speed rewriting, it is necessary that a time required for heating and a time required for heat radiation are short. The rapid heating can be controlled in accordance with application of a voltage and a current from the outside. However, the heat radiation depends on the thermal conduction to the circumference after cut-off of the voltage and the current. To realize the rapid rewriting operation, therefore, a structure is adopted in which a material whose state changes between a noncrystalline state and a crystalline state contacts a material having excellent thermal conduction.

In addition, in order to prevent the co-existence of the crystalline state and the noncrystalline state in the variable resistance material, the variable resistance material is made to be changed to either the noncrystalline state or the crystal state. Thus, metal electrode materials are disposed in an upper bottom portion and a lower bottom portion of the variable resistance material. In this case, areas of the metal electrode materials are the same as those of the upper bottom portion and the lower bottom portion of the variable resistance material. Also, for the rapid heat radiation, the variable resistance material is disposed in a wiring structure not including a silicon material between these electrodes.

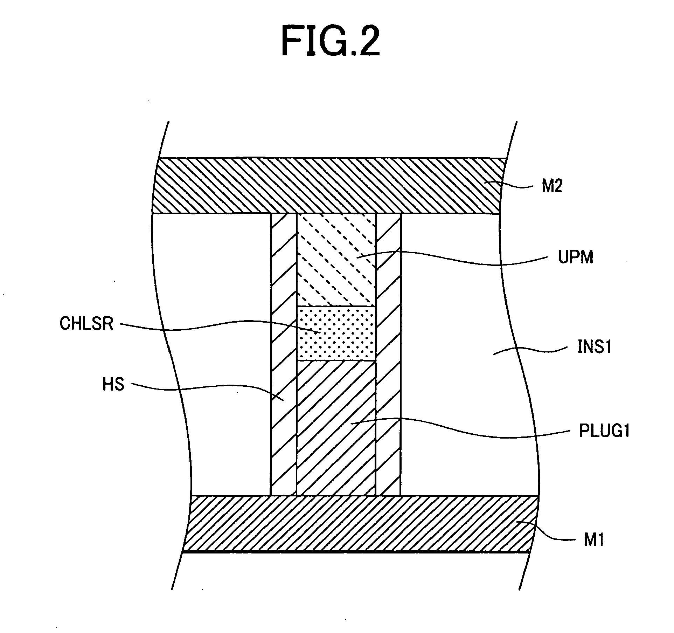

The structure described above is shown in FIG. 2. A variable resistance material CHLSR contacts a lower columnar electrode PLUG1 in its lower portion, and also contacts an upper electrode UPM in its upper portion. A contact area between CHLSR and UPM is the same as that between CHLSR and PLUG1. As a result, a current path becomes uniform, so that the entire variable resistance material becomes a noncrystalline state or a crystalline state. In addition, a sidewall of CHLSR contacts a material HS having a higher thermal conductivity than that of an interlayer insulating film INS1, and thus the heat rapidly radiates from CHLSR. As a result, the amorphization or crystallization of CHLSR rapidly progresses. Note that, any one of a silicon nitride film, a silicon carbide film, an aluminum oxide film, an aluminum nitride film, a titanium oxide film or a titanium nitride film is used as the material HS having the higher thermal conductivity than that of the interlayer insulating film INS1.

A lamination layer including the upper electrode, the variable resistance material, and the lower electrode, is subjected to the dry etching treatment in a self-aligned manner with respect to the upper electrode, thereby obtaining this structure.

### Effects of the Invention

With the structure described above, the present invention can realize a non-volatile storage device with high-speed rewriting. In addition, since the contact area between the variable resistance material and the upper electrode is equal to that between the variable resistance material and the lower electrode, the heating is prevented from being biased toward one of the upper electrode and the lower electrode. As a result, the crystalline state and the noncrystalline state can be prevented from co-existing in the inside of the variable resistance material, and thus it is possible to realize the non-volatile storage device capable of maintaining information for a long time. As a result, it is possible to realize a non-volatile random access memory and a reliable non-volatile storage device. In addition, installing such a memory or device as the non-volatile storage device in the semiconductor processing device makes it possible to provide a microcomputer, an IC card and the like each capable of freely rewriting a program stored therein and each with high reliability.

### Best Mode for Carrying Out the Invention

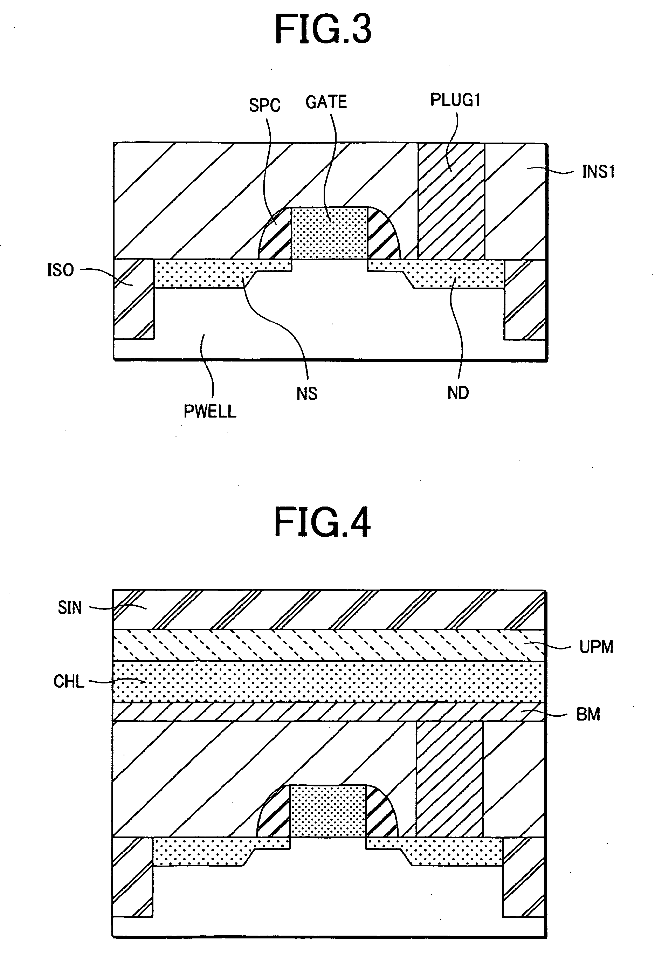

All examples given below which do not fall under the scope of the invention as set out in the appended claims are not to be considered as embodiments of the invention.
A description will now be made of a non-volatile storage device including a variable resistance material according to an embodiment of the present invention and a method of manufacturing the same with reference to FIGS. 3 to 9. It is assumed that the variable resistance material is connected to a drain side of a MOS transistor. FIG. 3 shows a known MOS transistor used in a semiconductor integrated circuit device. The MOS transistor includes an element isolation trench ISO, a p-type well PWE, an n-type source NS, an n-type drain ND, a gate electrode GATE, and a sidewall spacer SPC. A plug wiring PLUG1 is disposed and connected to the variable resistance material on the n-type drain ND. It should be noted that wiring to the n-type source NS is not illustrated to prevent the figures from being complicated.

Referring to FIG. 4, a lower electrode layer BM, a variable resistance material CHL, an upper electrode layer UPM, and an insulating layer SIN are deposited in this order on the structure shown in FIG. 3. It is preferable that SIN be formed of a silicon oxide film or a silicon nitride film which is formed by utilizing a plasma-chemical vapor deposition method. This is because when a chemical vapor deposition method is utilized at a low pressure, a deposition temperature becomes high and thus CHL becomes volatile.

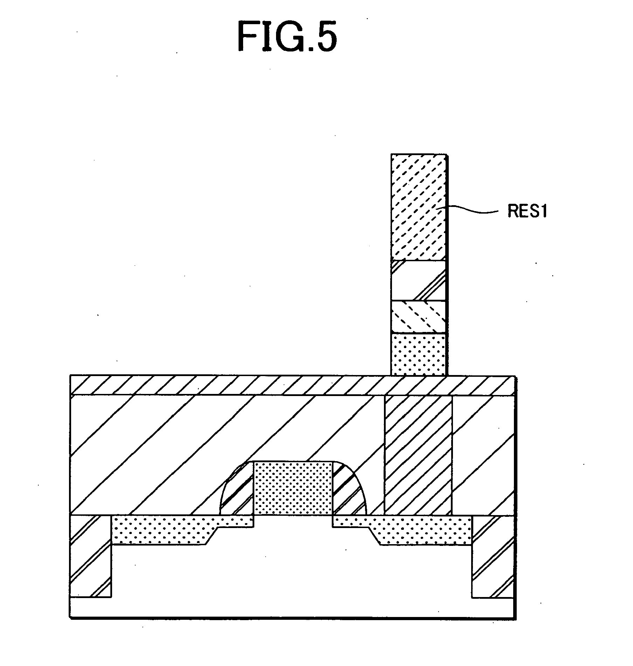

Referring to FIG. 5, the structure shown in FIG. 4 is processed by utilizing a known lithography technique and a known dry etching technique. Reference symbol RES1 designates a photo-resist used in this process. The dry etching is stopped right before BM is etched.

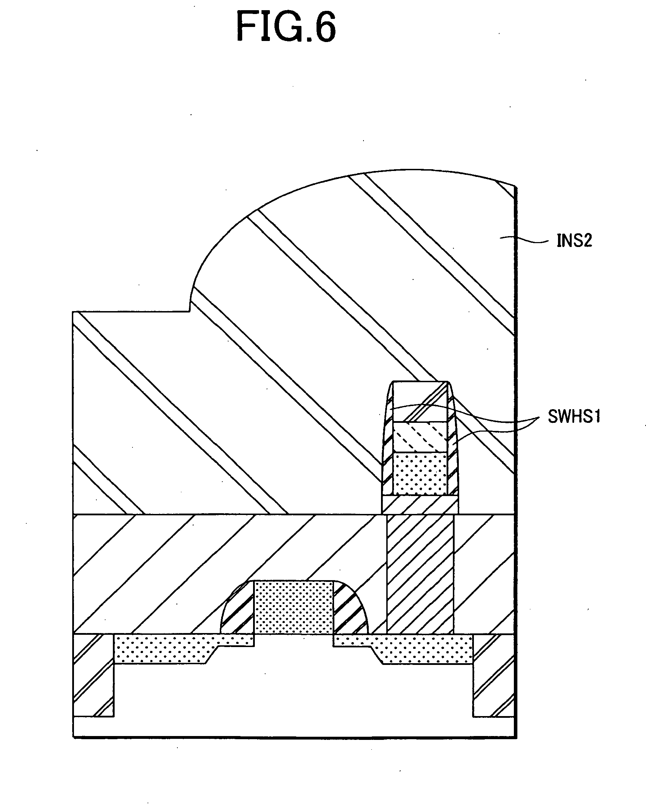

A description will now be given with reference to FIG. 6. After RES1 shown in FIG. 5 is removed, a sidewall spacer SWHS1 is disposed on a sidewall of the lamination film including CHL, UPM and SIN which has been previously processed. After that, the entire structure is coated with an insulating film INS2. The sidewall spacer SWHS1 is made of a material having a higher thermal conductivity than that of the material of INS2. When INS2 is formed of a deposited- silicon oxide film, the material for SWHS1 may be a silicon nitride film, a silicon carbide film, an aluminum oxide film, an aluminum nitride film, a titanium oxide film, a titanium nitride film or the like. A lower portion of SWHS1 contacts the metallic material BM, which contributes to the speedy thermal diffusion from CHL. The reason for processing BM after SWHS1 is provided will now be described. The processing for CHL is firstly started from the alignment with PLUG1 by utilizing the lithography technique (FIG. 5). At this time, the misalignment in terms of the manufacture almost surely occurs. If the process is made to BM with the misalignment, the contact area between BM and PLUG1 may vary, thereby to vary the current. This results in the fluctuation in the characteristics of the element. In order to prevent the variation, the area of BM is increased by providing SWHS1 after completion of the process so that PLUG1 is necessarily coated with BM even when the above-mentioned misalignment occurs. Thus, the contact area between BM and PLUG1 can be made constant.

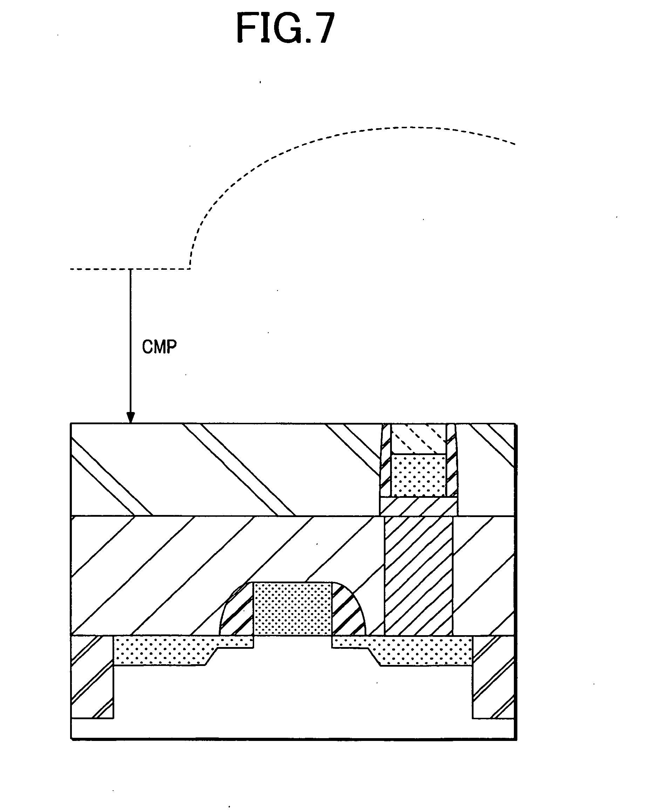

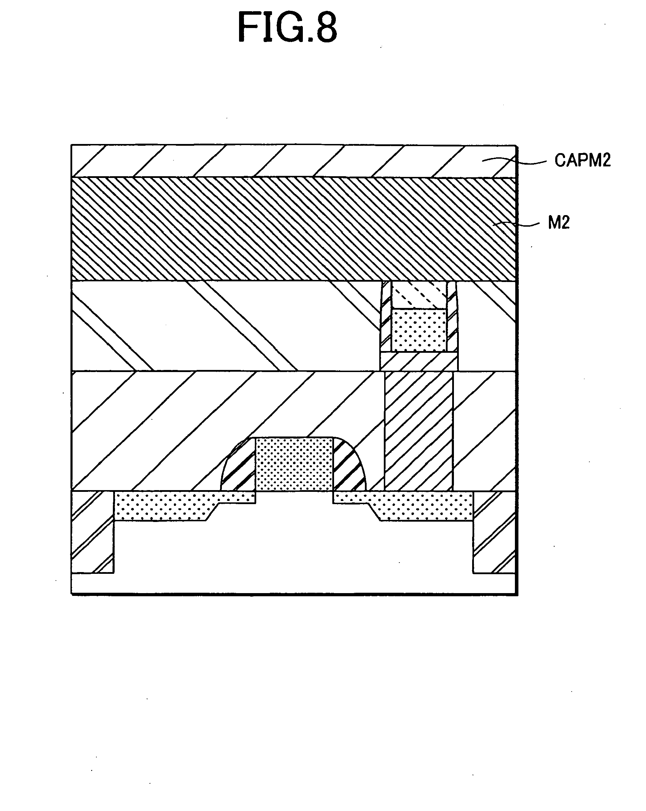

Referring now to FIG. 7, the CMP (chemical mechanical polishing) is performed for the structure shown in FIG. 6. At this time, SIN is completely removed to expose the upper electrode UPM.
Referring to FIG. 8, a metallic wiring layer M2 and a protective film CAPM2 are deposited in this order on the structure shown in FIG. 7.

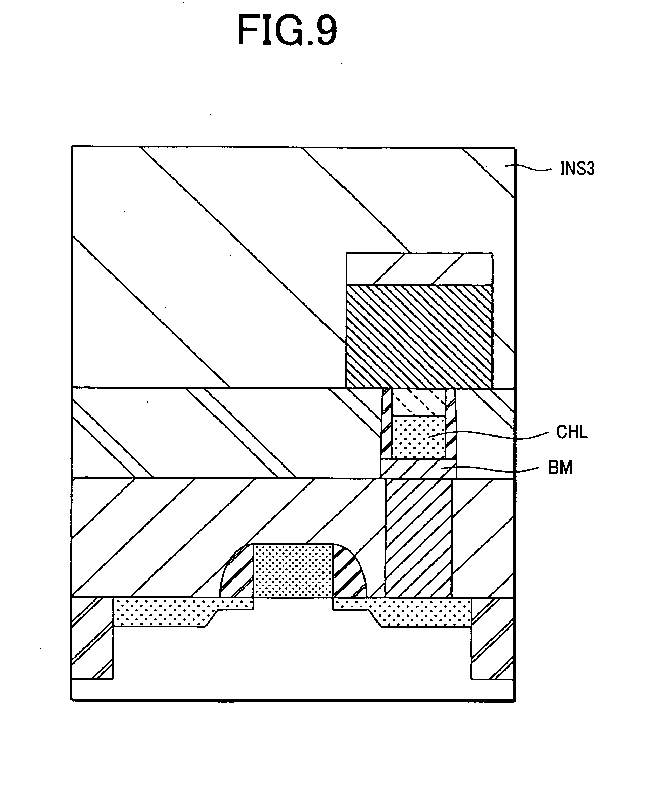

FIG. 9 shows a structure in which after the structure shown in FIG. 8 is processed by utilizing the known lithography and dry etching techniques, the resulting entire structure is coated with a deposited-silicon oxide film. Although a desired wiring layer is formed after completion of this process by utilizing a known method, the formation of the desired wiring layer is omitted in the figure.

Here, the Joule heat generated in CHL radiates through UPM and BM. However, since the metallic wiring layer M2 is connected to UPM, the cooling effect is higher in the case of the heat radiation to the UPM side than in the case of the heat radiation to the BM side. Therefore, a thickness of UPM is made smaller than the total of a height of PLUG1 and a thickness of BM, thereby enhancing the effect of the heat radiation utilizing M2.

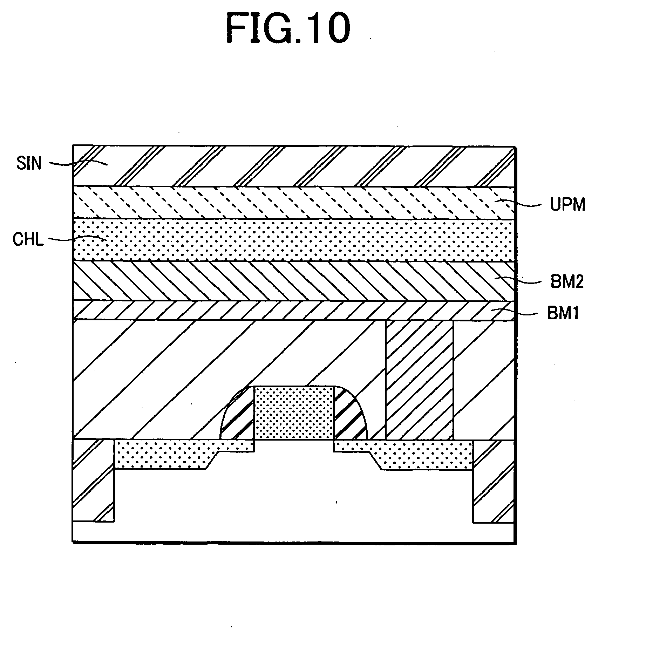

Another embodiment will be described hereinafter with reference to FIGS. 10 to 12. This embodiment is such that three layers consisting of the lower electrode, the variable resistance material, and the upper electrode are formed into one columnar structure. Thus, this embodiment aims at obtaining a more uniform flow of the current than that in the embodiment shown in FIG. 9.

FIG. 10 shows a structure in which lower electrode layers BM1 and BM2, a variable resistance material CHL, an upper electrode UPM, and an insulating layer SIN are successively deposited on a known MOS transistor.

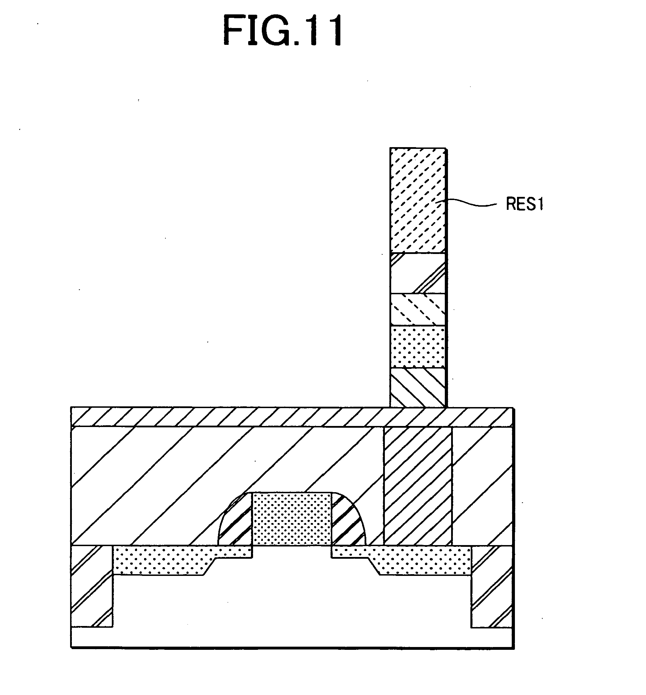

This structure is processed by utilizing the same method as that in FIG. 5, and BM1 is left as it is without being processed (FIG. 11).

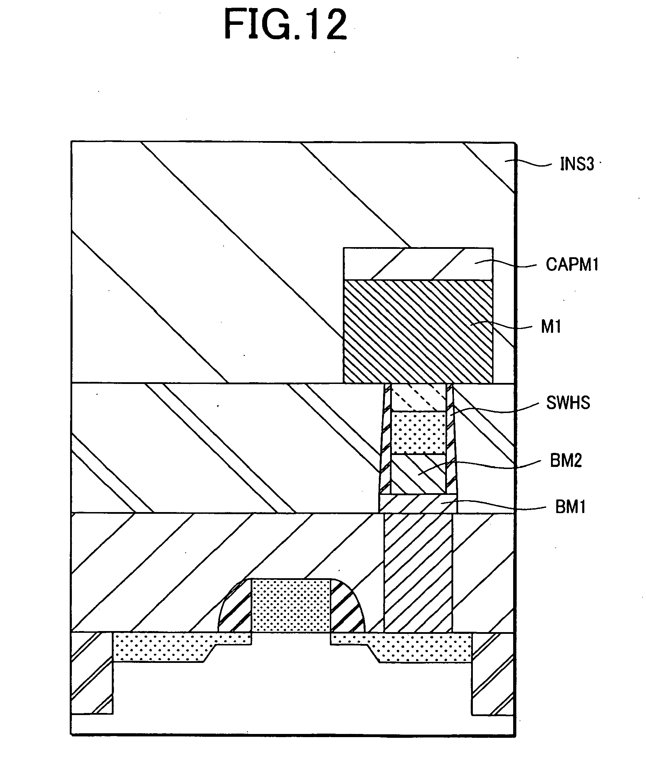

After this process, the manufacturing procedures corresponding to those shown in FIGS. 6 to 8 are completed to obtain a structure shown in FIG. 12. A difference in structure between FIG. 9 and FIG. 12 is that CML contacts BM2 which has the same columnar structure as that of CHL. That is to say, the path of the current which is caused to flow through the three layers consisting of BM2, CHL and UPM has no portion in which the current concentrates, which contributes to the uniform heat generation within the variable resistance material, which is one of the objects of the present invention. It should be noted that SWHS has a high thermal conductivity and is disposed so as to contact the sidewall of the variable resistance material CHL, and the material for SWHS may be a silicon nitride film, a silicon carbide film, an aluminum oxide film, an aluminum nitride film, a titanium oxide film, a titanium nitride film or the like, similarly to the case of the structure shown in FIG. 9.

In addition, in FIG. 9, BM contacting the lower portion of CHL has the larger area than that of CHL, whereas in FIG. 12, BM2 contacting the lower portion of CHL has the same area as that of CHL. In the case of the structure shown in FIG. 9, a current which is caused to flow completely through CHL and BM is not caused to flow vertically from the lower end portion of CHL to BM. A part of the current is caused to flow through a path which obliquely projects to the outer end portion side of BM. As a result, the current path becomes partially nonuniform. BM2 has the same area as that of CHL and is disposed on BM1 to cause the current to flow through the uniform path even in the end portion of CHL.

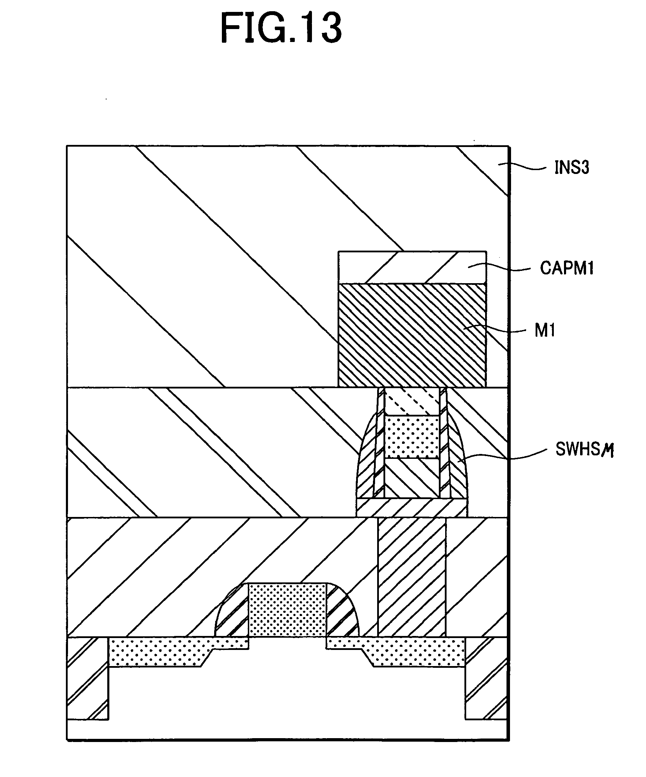

FIG. 13 shows still another embodiment. A structure shown in FIG. 13 has a shape in which BM1 is processed after a sidewall SWHSM having excellent thermal conduction is further disposed on the outside of SWHS shown in FIG. 12. SWHSM is preferably made of a metallic material. In this case, SWHSM must be formed to have a lower height than that of SWHS in order to prevent SWHSM from contacting M1 after completion of CMP. With SWHSM, heat radiation with a higher speed can be expected than that in the case of the structure shown in FIG. 9.

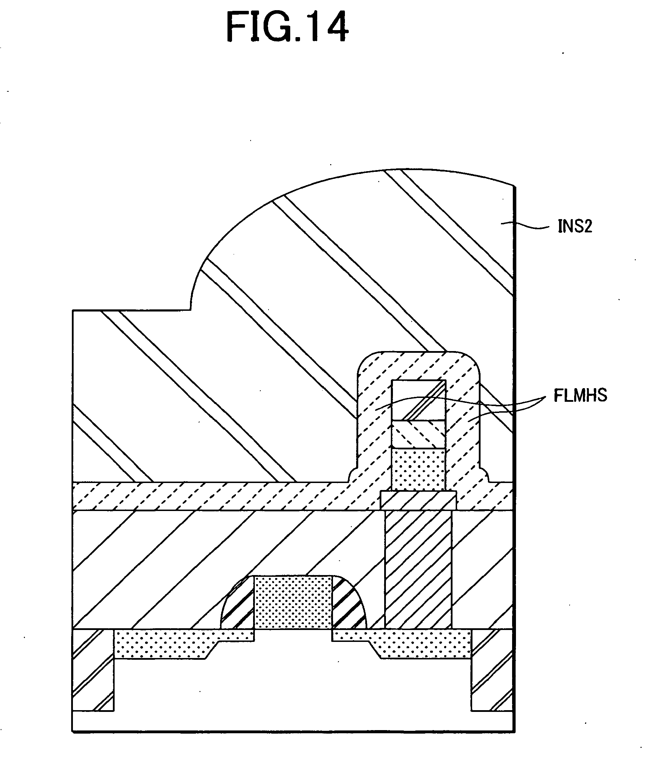

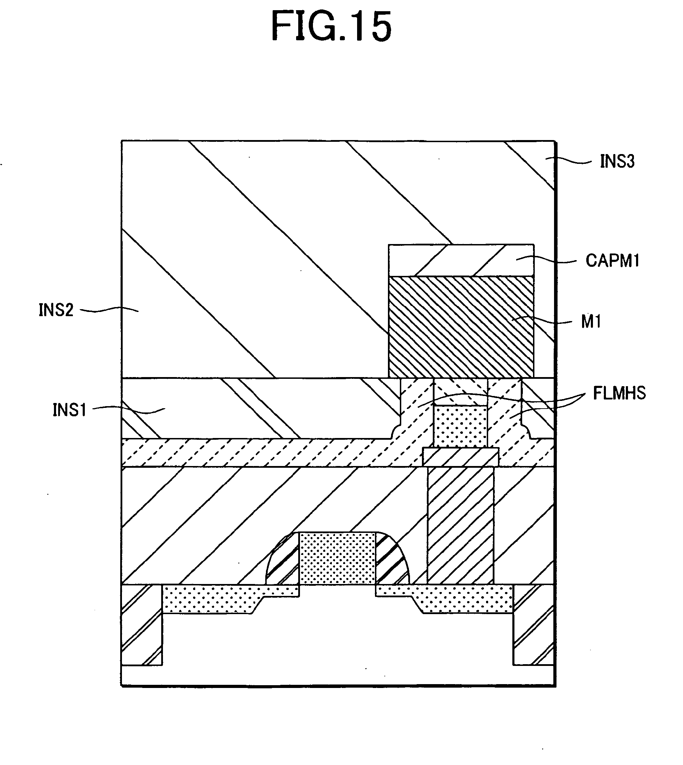

Structures shown in FIGS. 14 and 15 are adopted in yet another embodiment in the case where a material having excellent thermal conduction and contacting the sidewall of CHL is not formed into a spacer shape. FIG. 14 shows a process corresponding to that shown in FIG. 6. However, the process shown in FIG. 14 is different from that shown in FIG. 6 in that SWHS1 existing in the process shown in FIG. 6 is removed by the cleaning, and a layer FLMHS having a high thermal conductivity is deposited on the whole surface of the structure instead. After that, processes corresponding to those shown in FIGS. 7 to 9 successively progress to form the structure shown in FIG. 15. Since FLMHS is only deposited, it is made thicker than SWHS1 described with reference to FIGS. 3 to 9. For this reason, it is possible to expect the higher heat radiation effect than that of SWHS1**.** The material for FLMHS may be a silicon nitride film, a silicon carbide film, an aluminum oxide film, an aluminum nitride film, a titanium oxide film, a titanium nitride film or the like which is formed by utilizing a sputtering method or a plasma-chemical vapor deposition method.

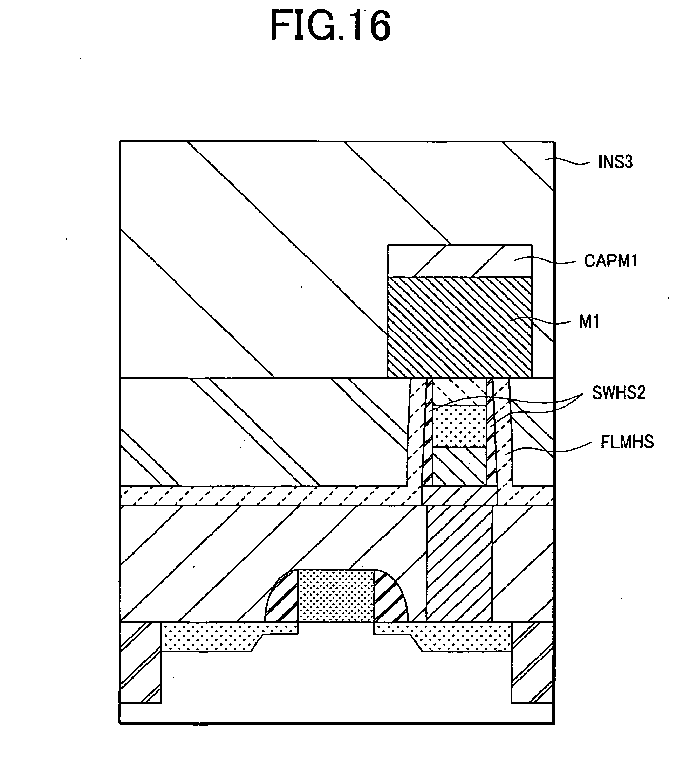

FIG. 16 shows a structure in which FLMHS is deposited with SWHS2 formed on the sidewall of CHL being left as it is. A material for SWHS2 may be the same as that of FLMHS. Thus, the material for SWHS2 may be a silicon nitride film, a silicon carbide film, an aluminum oxide film, an aluminum nitride film, a titanium oxide film, a titanium nitride film or the like. Although the heat radiation effect of this structure is the same as that of the structure shown in FIG. 15, there is the merit that the number of processes can be reduced because the process for removing SWHS is unnecessary.

### Industrial Applicability

As set forth hereinabove, it is possible to realize the non-volatile random access memory and the reliable non-volatile storage device. In addition, when such a memory or device is installed as the non-volatile storage device in the semiconductor arithmetic-logic device, it is suitable for a microcomputer, an IC card and the like each capable of freely rewriting a program stored therein and each with high reliability.

### Brief Description of Drawings

FIG. 1 is a cross sectional view of a known non-volatile storage device using a variable resistance material.
FIG. 2 is a conceptual view of a structure of a non-volatile storage device using a variable resistance material used to explain a concept leading to the present invention.
FIG. 3 is a cross sectional view of a structure in a manufacturing process of a device according to the present invention.
FIG. 4 is another cross sectional view of the structure in the manufacturing process of a device according to the present invention.
FIG. 5 is another cross sectional view of the structure in the manufacturing process of a device according to the present invention.
FIG. 6 is another cross sectional view of the structure in the manufacturing process of a device according to the present invention.
FIG. 7 is another cross sectional view of the structure in the manufacturing process of a device according to the present invention.
FIG. 8 is another cross sectional view of the structure in the manufacturing process of a device according to the present invention.
FIG. 9 is another cross sectional view of the structure in the manufacturing process of a device according to of the present invention.
FIG. 10 is a cross sectional view of another structure in the manufacturing process of a device according to of the present invention.
FIG. 11 is another cross sectional view of the other structure in the manufacturing process of a device according to the present invention.
FIG. 12 is another cross sectional view of the other structure in the manufacturing process of a device according to the present invention.
FIG. 13 is another cross sectional view of the other structure in the manufacturing process of a device according to the present invention.
FIG. 14 is a cross sectional view of still another structure in the manufacturing process of a device according to the present invention.
FIG. 15 is another cross sectional view of the still other structure in the manufacturing process of a device according to the present invention.
FIG. 16 is another cross sectional view of the still other structure in the manufacturing process of a device according to the present invention.

### Description of Characters

**M1** ... lower wiring layer
PLUG1 ... plug wiring to connect M1 and CHL
UPM ... upper electrode contacting an upper portion of CHL
M2 ... upper wiring layer
PLUG2 ... plug wiring to connect UPM and M2
CHLSR ... region with a variable resistance in CHL
CHLB ... region not contributing to a variable resistance in CHL,
CHL ... variable resistance material
SWHS ... sidewall spacer made of a material with a high thermal conductivity and disposed so as to contact sidewall of CHL
SWHSM ... sidewall spacer made of a metal and disposed outside SWHS so as to contact SWHS
SWHS1 ... a sidewall spacer of CHL
FLMHS an insulating film having more excellent thermal conduction than that of INS2 and deposited so as to contact CHL
SWHS2 ... sidewall spacer made of the same material as that of FLMHS and deposited so as to contact CHL
INS1 ... interlayer film (first level),
INS2 ... interlayer film (second level),
INS3 ... interlayer film (third level),
HS ... layer made of a material having a high thermal conductivity and disposed so as to contact the sidewall of CHL
GATE ... gate electrode of an n-channel MOS transistor
SPC ... insulating film spacer formed on a sidewall of GATE
NS ... N-type source region
ND ... N-type drain region
ISO ... isolation region
SIN ... silicon nitride film disposed on UPM
UPM ... upper electrode layer
BM ... lower electrode layer
RES1 ... photo-resist used as a mask for processing UPM, CHL and BM
CAPM2 ... insulating film disposed on M2,
M1, ME1... lower wiring layer,
M2, ME2 upper wiring layer.

## Claims

1. A non-volatile storage device, comprising:
a first conductive layer (BM1) formed above a substrate;
a laminated film that has a third conductive layer (BM2) formed on the first conductive layer (BM1), and a variable resistance layer (CHL) formed on the third conductive layer (BM2), and a fourth conductive layer (UPM) formed on the variable resistance layer (CHL), and a second conductive layer (M1) formed on the fourth conductive layer (UPM), the variable resistance layer (CHL) being changed to either one of a crystalline state or a noncrystalline state depending on heat conditions so as to change a resistance value of the variable resistance layer (CHL);
**characterized by**
an insulating film (SWHS) formed continuously to contact on a side wall of the third conductive layer (BM2), a sidewall of the variable resistance layer (CHL), a sidewall of the fourth conductive layer (UPM), a connection part between the variable resistance layer (CHL) and the third conductive layer (BM2), and a connection part between the variable resistance layer (CHL) and the fourth conductive layer (UPM) and contacted at least either a surface of the first conductive layer (BM1) or a surface of the second conductive layer (M1); and
an interlayer insulating film (INS2) formed so as to surround the first conductive layer and the insulating film,
wherein a contact area between the variable resistance layer (CHL) and the third conductive layer (BM2) is the same as a contact area between the variable resistance layer (CHL) and the fourth conductive layer (UPM),
wherein the insulating film (SWHS) is formed of a material having a higher thermal conductivity than that of interlayer insulating film.

2. The non-volatile storage device according to claim 1, further comprising a transistor including a diffusion layer (ND) formed in the substrate,
wherein the first conductive layer (BM1) and the diffusion layer (ND) are electrically connected to each other through a plug (PLUG1) layer.

3. The non-volatile storage device according to claim 2, wherein the first conductive layer (BM1) is formed so as to cover a contact surface between the first conductive layer (BM1) and the plug (PLUG1) layer.

4. The non-volatile storage device according to claim 1, wherein the insulating film (SWHS) is formed of any one of a silicon nitride film, a silicon carbide film, an aluminum oxide film, an aluminum nitride film, a titanium oxide film or a titanium nitride film.

5. The non-volatile storage device according to any of claims 1 to 4, further comprising another insulating film (FLMHS), the other insulating film (FLMHS) being formed so as to surround the insulating film (SWHS2) and the first conductive layer (BM1), wherein the other insulating film is made of a material having a higher thermal conductivity than that of the interlayer insulating film.

6. The non-volatile storage device according to claim 5, wherein each of the insulating film (SWHS2) and the other insulating film (FLMHS) is formed of any one of a silicon nitride film, a silicon carbide film, an aluminum oxide film, an aluminum nitride film, a titanium oxide film or a titanium nitride film.

7. The non-volatile storage device according to claim 1, wherein a laminated film consisting of the second conductive layer (M1), the variable resistance layer (CHL) and the third conductive layer (BM2) is subjected to dry etching treatment in a self-aligned manner with respect to the second conductive layer (M1).

8. The non-volatile storage device according to claim 1, wherein the third conductive layer (BM2) is a laminated layer of a plurality of metallic materials that are different from each other.

9. A non-volatile storage device according to claim 1, further comprising a conductive film (SWHSM) that is formed so as to cover a part of a sidewall of the insulating film (SWHS) and that is disposed so as to contact one surface of the conductive film (SWHSM) with a surface of the first conductive layer (BM1).

10. A non-volatile storage device according to claim 9, wherein the conductive film (SWHSM) is formed of a sidewall spacer having one end that is thinner than the other end in cross section.

## Patentansprüche

1. Nichtflüchtige Speichervorrichtung, die Folgendes aufweist:
- eine erste leitfähige Schicht (BM1), die oberhalb eines Substrats ausgebildet ist;
- eine mehrlagige Schicht, die eine auf der ersten leitfähigen Schicht (BM1) ausgebildete dritte leitfähige Schicht (BM2), eine auf der dritten leitfähigen Schicht (BM2) ausgebildete Schicht variablen Widerstands (CHL), eine auf der Schicht variablen Widerstands (CHL) ausgebildete vierte leitfähige Schicht (UPM) und eine auf der vierten leitfähigen Schicht (UPM) ausgebildete zweite leitfähige Schicht (M1) aufweist, wobei die Schicht variablen Widerstands (CHL) von Wärmebedingungen abhängig entweder in einen kristallinen Zustand oder einen nichtkristallinen Zustand überführt wird, um einen Widerstandswert der Schicht variablen Widerstands (CHL) zu ändern;
**gekennzeichnet durch**
- eine Isolierschicht (SWHS), die durchgehend ausgebildet ist, um eine Seitenwand der dritten leitfähigen Schicht (BM2), eine Seitenwand der Schicht variablen Widerstands (CHL), eine Seitenwand der vierten leitfähigen Schicht (UPM), einen Verbindungsbereich zwischen der Schicht variablen Widerstands (CHL) und der dritten leitfähigen Schicht (BM2) und einen Verbindungsbereich zwischen der Schicht variablen Widerstands (CHL) und der vierten leitfähigen Schicht (UPM) zu kontaktieren und die zumindest entweder eine Oberfläche der ersten leitfähigen Schicht (BM1) oder eine Oberfläche der zweiten leitfähigen Schicht (M1) kontaktiert; und
- eine Trennisolierschicht (INS2), die so ausgebildet ist, dass sie die erste leitfähige Schicht und die Isolierschicht umgibt,
wobei eine zwischen der Schicht variablen Widerstands (CHL) und der dritten leitfähigen Schicht (BM2) ausgebildete Kontaktfläche gleich einer zwischen der Schicht variablen Widerstands (CHL) und der vierten leitfähigen Schicht (UPM) ausgebildeten Kontaktfläche ist, und
wobei die Isolierschicht (SWHS) aus einem Material gebildet ist, das eine höhere thermische Leitfähigkeit aufweist als das Material der Trennisolierschicht.

2. Nichtflüchtige Speichervorrichtung nach Anspruch 1, die ferner einen Transistor aufweist, der eine in dem Substrat ausgebildete Diffusionsschicht (ND) umfasst,
wobei die erste leitfähige Schicht (BM1) und die Diffusionsschicht (ND) durch eine Anschlussschicht (PLUG1) elektrisch miteinander verbunden sind.

3. Nichtflüchtige Speichervorrichtung nach Anspruch 2, worin die erste leitfähige Schicht (BM1) so ausgebildet ist, dass sie eine Kontaktfläche zwischen der ersten leitfähigen Schicht (BM1) und der Anschlussschicht (PLUG1) bedeckt.

4. Nichtflüchtige Speichervorrichtung nach Anspruch 1, worin die Isolierschicht (SWHS) als Siliciumnitridschicht, Siliciumcarbidschicht, Aluminiumoxidschicht, Aluminiumnitridschicht, Titanoxidschicht oder als Titannitridschicht ausgebildet ist.

5. Nichtflüchtige Speichervorrichtung nach einem der Ansprüche 1 bis 4, die ferner eine weitere Isolierschicht (FLMHS) aufweist, wobei die weitere Isolierschicht (FLMHS) so ausgebildet ist, dass sie die Isolierschicht (SWHS2) und die erste leitfähige Schicht (BM1) umgibt, wobei die weitere Isolierschicht aus einem Material ausgeführt ist, das eine höhere thermische Leitfähigkeit aufweist als das Material der Trennisolierschicht.

6. Nichtflüchtige Speichervorrichtung nach Anspruch 5, worin sowohl die Isolierschicht (SWHS2) als auch die weitere Isolierschicht (FLMHS) jeweils als Siliciumnitridschicht, Siliciumcarbidschicht, Aluminiumoxidschicht, Aluminiumnitridschicht, Titanoxidschicht oder als Titannitridschicht ausgebildet sind.

7. Nichtflüchtige Speichervorrichtung nach Anspruch 1, worin eine aus der zweiten leitfähigen Schicht (M1), der Schicht variablen Widerstands (CHL) und der dritten leitfähigen Schicht (BM2) bestehende mehrlagige Schicht einem sich bezüglich der zweiten leitfähigen Schicht (M1) selbstjustierenden Trockenätzprozess unterzogen wird.

8. Nichtflüchtige Speichervorrichtung nach Anspruch 1, worin die dritte leitfähige Schicht (BM2) als mehrlagige Schicht aus mehreren voneinander verschiedenen metallischen Materialien ausgebildet ist.

9. Nichtflüchtige Speichervorrichtung nach Anspruch 1, die ferner eine leitfähige Schicht (SWHSM) aufweist, die so ausgebildet ist, dass sie einen Teil einer Seitenwand der Isolierschicht (SWHS) bedeckt, und die so angeordnet ist, dass eine Oberfläche der leitfähigen Schicht (SWHSM) von einer Oberfläche der ersten leitfähigen Schicht (BM1) kontaktiert wird.

10. Nichtflüchtige Speichervorrichtung nach Anspruch 9, worin die leitfähige Schicht (SWHSM) von einem Seitenwanddistanzstück gebildet ist, dessen eines Ende im Querschnitt dünner als dessen anderes Ende ist.

## Revendications

1. Dispositif de mémoire non volatile, comprenant :
une première couche conductrice (BM1) formée au-dessus d'un substrat ;
un film stratifié qui possède une troisième couche conductrice (BM2) formée sur la première couche conductrice (BM1), une couche à résistance variable (CHL) formée sur la troisième couche conductrice (BM2), une quatrième couche conductrice (UPM) formée sur la couche à résistance variable (CHL) et une seconde couche conductrice (M1) formée sur la quatrième couche conductrice (UPM), la couche à résistance variable (CHL) passant à un état cristallin ou à un état non cristallin selon les conditions de chaleur pour changer une valeur de résistance de la couche à résistance variable (CHL) ;
**caractérisé par**
un film isolant (SWHS) formé en continu, de manière à être en contact, sur une paroi latérale de la troisième couche conductrice (BM2), sur une paroi latérale de la couche à résistance variable (CHL), sur une paroi latérale de la quatrième couche conductrice (UPM), sur une partie de liaison entre la couche à résistance variable (CHL) et la troisième couche conductrice (BM2) et sur une partie de liaison entre la couche à résistance variable (CHL) et la quatrième couche conductrice (UPM) et mis en contact avec au moins une surface de la première couche conductrice (BM1) ou une surface de la seconde couche conductrice (M1) ; et
un film isolant intermédiaire (INS2) formé de manière à entourer la première couche conductrice et le film isolant,
une zone de contact entre la couche à résistance variable (CHL) et la troisième couche conductrice (BM2) étant la même qu'une zone de contact entre la couche à résistance variable (CHL) et la quatrième couche conductrice (UPM),
dans lequel le film isolant (SWHS) est formé d'un matériau ayant une conductivité thermique supérieure à celle du film isolant intermédiaire.

2. Le dispositif de mémoire non volatile selon la revendication 1, comprenant en outre un transistor incluant une couche de diffusion (ND) formée dans le substrat,
Dans lequel la première couche conductrice (BM1) et la couche de diffusion (ND) sont reliées électriquement l'une à l'autre par l'intermédiaire d'une couche de connexion (PLUG1).

3. Le dispositif de mémoire non volatile selon la revendication 2, dans lequel la première couche conductrice (BM1) est formée de manière à recouvrir une surface de contact entre la première couche conductrice (BM1) et la couche de connexion (PLUG1).

4. Le dispositif de mémoire non volatile selon la revendication 1, dans lequel le film isolant (SWHS) est formé d'un film de nitrure de silicium, d'un film de carbure de silicium, d'un film d'oxyde d'aluminium, d'un film de nitrure d'aluminium, d'un film d'oxyde de titane ou d'un film de nitrure de titane.

5. Le dispositif de mémoire non volatile selon l'une quelconque des revendications 1 à 4, comprenant en outre un autre film isolant (FLMHS), l'autre film isolant (FLMHS) étant formé de manière à entourer le film isolant (SWHS2) et la première couche conductrice (BM1) et étant constitué d'un matériau ayant une conductivité thermique supérieure à celle du film isolant intermédiaire.

6. Le dispositif de mémoire non volatile selon la revendication 5, dans lequel le film isolant (SWHS2) et l'autre film isolant (FLMHS) sont formés chacun d'un film de nitrure de silicium, d'un film de carbure de silicium, d'un film d'oxyde d'aluminium, d'un film de nitrure d'aluminium, d'un film d'oxyde de titane ou d'un film de nitrure de titane.

7. Le dispositif de mémoire non volatile selon la revendication 1, dans lequel un film stratifié constitué de la seconde couche conductrice (M1), de la couche à résistance variable (CHL) et de la troisième couche conductrice (BM2) est soumis à un traitement de gravure sèche de manière auto-alignée par rapport à la seconde couche conductrice (M1).

8. Le dispositif de mémoire non volatile selon la revendication 1, dans lequel la troisième couche conductrice (BM2) est une couche stratifiée composée de plusieurs matériaux métalliques qui sont différents les uns des autres.

9. Dispositif de mémoire non volatile selon la revendication 1, comprenant en outre un film conducteur (SWHSM) qui est formé de manière à recouvrir une partie d'une paroi latérale du film isolant (SWHS) et qui est disposé de manière à mettre en contact une surface du film conducteur (SWHSM) avec une surface de la première couche conductrice (BM1).

10. Dispositif de mémoire non volatile selon la revendication 9, dans lequel le film conducteur (SWHSM) est formé d'un espaceur de paroi latérale présentant une extrémité dont la section transversale est plus mince que celle de l'autre extrémité.
